# EUROPEAN PATENT APPLICATION

(11) **EP 1 826 769 A2**
(43) Date of publication of application: **29.08.2007**
(21) Application number: 07250166.1
(22) Date of filing: 17.01.2007
(51) Int. Cl.: G11C 7/22, G11C 7/10, G11C 5/00

(54) **Memory module**

(30) Priority: 27.02.2006 JP 2006050770
(71) Applicant: FUJITSU LIMITED, Kawasaki-shi, Kanagawa 211-8588 (JP)
(72) Inventor: Nakano, Rikizo, c/o Fujitsu Limited, Kawasaki-shi, Kanagawa 211-8588 (JP)
(74) Representative: Stebbing, Timothy Charles

(57) **Abstract**

A memory module having an array of memory devices (16), mounted thereon, that operate synchronously with a clock signal (CLK, /CLK), wherein provisions are made to be able to fine-tune the clock phase in accordance with its use conditions. The memory module includes: a phase-locked loop circuit which produces an output clock signal (RCK, /RCK) adjusted so that the phase of a feedback signal obtained by passing the output clock signal through a feedback loop matches the phase of an input clock signal; and a switching unit (80) which selectively changes a load (24, 26) in the feedback loop in accordance with an external signal.

## Description

The present invention relates to a memory module having an array of memory devices, mounted thereon, that operate synchronously with a clock signal.

Currently, SDRAM (Synchronous Dynamic Random Access Memory) is the predominant type of memory as main memory for personal computers, etc. The SDRAM has the characteristic of achieving high access speeds by operating synchronously with the system bus clock, and is often used in the form of a DIMM (Dual In-line Memory Module). The DIMM is a memory module that has separate independent contacts on either side, the combined number of pins on both sides being, for example, 184, and is capable of transferring data in blocks of 72 bits.

In the DIMM, clock distribution is performed using a PLL (Phase-Locked Loop) circuit mounted on the DIMM; that is, the PLL circuit adjusts the phase of the clock signal input via a terminal of the DIMM, and distributes the phase-adjusted clock signal to the designated terminals of the respective memory devices. Such phase adjustment is done, during the development of the DIMM, so that the delay of the clock signal from the terminal of the DIMM to the terminal of each memory device will be zero.

However, as the load differs between different memory devices (different makes, different capacities, different mounting methods, etc.), a phase error can occur even if the circuit board based on the same Gerber data or a JEDEC standard circuit board is used. When fabricating a printed circuit board, information such as mask patterns and printing patterns for printing characters, etc. on the circuit board surface becomes necessary in addition to wiring patterns; these pieces of information are collectively called the "Gerber data". Here, JEDEC stands for Joint Electron Device Engineering Council, a U.S. standardization body for electronic devices.

Further, depending on how DIMMs are used (the number of slots used, a mixture of DIMMs of different capacities, etc.), a large skew can occur in the output data, resulting in the problem that the output detection window cannot be determined.

Japanese Unexamined Patent Publication No. H09-190239, a prior art document related to the present invention, discloses a clock skew adjusting circuit which outputs a clock to a synchronization circuit by compensating for an input delay of the clock from a clock driver, the clock skew adjusting circuit comprising a phase-locked loop which outputs the clock by making an adjustment so that the clock input and the feedback input have a predetermined phase relationship, wherein an inverting circuit for inverting an input signal for output is inserted in a feedback path through which the clock output from the phase-locked loop is fed back to a feedback input.

Further, Japanese Unexamined Patent Publication No. 2000-163999 discloses a self-timing control circuit which delays a supplied clock and thereby generates a timing clock having a predetermined phase relationship with the supplied clock, the self-timing control circuit comprising a first variable delay circuit to which the supplied clock is input, and which delays the supplied clock by an amount controlled in accordance with the frequency of the supplied clock, and an additional delay circuit which is connected to the first variable delay circuit and which delays the supplied clock by a predetermined amount regardless of the frequency of the supplied clock, wherein the additional delay circuit includes a variable dummy load whose delay amount is variably set, and the delay amount of the variable dummy load is variably set by a programmable memory provided to set the delay amount.

On the other hand, Japanese Unexamined Patent Publication No. 2001-160000 discloses a memory control integrated circuit which controls SDRAM by receiving a signal from a higher-order device as well as an input clock, the memory control integrated circuit comprising a memory control section, a PLL, and a clock distribution section, wherein the memory control section outputs a signal,for controlling the SDRAM, the PLL receives the input clock and a feedback clock and supplies a clock, synchronized to the input clock and the feedback clock, to the clock distribution section, and the clock distribution section outputs an SDRAM clock to be supplied to the SDRAM, the feedback clock to be input to the PLL, and a read clock for latching data from the SDRAM.

Further, Japanese Unexamined Patent Publication No. 2001-186017 discloses a PLL circuit comprising an oscillator whose oscillation output frequency is controlled in accordance with a phase comparison result output from a phase comparator, a first low-pass filter to which the oscillator output is input, a buffer which produces an output that matches the result of the comparison between the filter output and a predetermined threshold value, and a control means for controlling the threshold value, wherein the phase comparator outputs the phase difference between the output of the buffer and the input signal to the comparator as the phase comparison result output, and the oscillation output of the oscillator is derived as the output of the PLL circuit.

The present invention has been devised in view of the above problem, and embodiments thereof may provide a memory module having an array of memory devices mounted thereon that operate synchronously with a clock signal, wherein provisions are made to be able to fine-tune the clock phase in accordance with its use conditions.

According to one aspect of the present invention, there is provided a memory module having an array of memory devices mounted thereon that operate synchronously with a clock signal, comprising: a phase-locked loop circuit which produces an output clock signal adjusted so that the phase of a feedback signal obtained by passing the output clock signal through a feedback loop matches the phase of an input clock signal; and a switching unit which selectively changes a load in the feedback loop in accordance with an external signal.

In one preferred mode, the switching unit changes a capacitance in the feedback loop.

Alternatively, the switching unit changes a resistance value in the feedback loop.

In one preferred mode, the switching unit selectively changes the load in the feedback loop in accordance with a value that is set in a register by a controller.

According to another aspect of the present invention, there is provided a memory module having an array of memory devices mounted thereon that operate synchronously with a clock signal, comprising: a phase-locked loop circuit which produces an output clock signal adjusted so that the phase of a feedback signal obtained by passing the output clock signal through a feedback loop matches the phase of an input clock signal; and a unit which, in accordance with an external signal, changes a reference level based on which a phase comparator circuit in the phase-locked loop circuit judges the value of the feedback signal.

According to the memory module of the present invention, even when there are differences in the memory devices mounted on the module or in the way the module is mounted in the host apparatus, the clock phase can be adjusted, and the reliability of the memory module can be enhanced.

The features and advantages of the present invention will be apparent from the following description with reference to the accompanying drawings, in which:
Figure 1 is a diagram showing the general configuration of a DIMM;
Figure 2 is a circuit diagram showing how a clock is distributed within the DIMM;
Figure 3 is a diagram showing the internal configuration of a PLL-based clock driver;
Figures 4A and 4B are diagrams for explaining different internal configurations for the DIMM;
Figure 5 is a diagram for explaining a different method of mounting the DIMM in a host apparatus;
Figures 6A, 6B, 6C, 6D, and 6E are timing charts showing the relationships among an input clock CLK to the DIMM, an input clock RCK to SDRAM, and output data DQS from the DIMM;
Figures 7A and 7B are diagrams for explaining how memory data are received by a controller;
Figure 8 is a diagram showing the circuit configuration of a DIMM according to one embodiment of the present invention;
Figure 9 is a diagram for explaining a DIMM according to another embodiment of the present invention; and
Figure 10 is a diagram for explaining the effect that can be achieved by making a reference voltage variable.

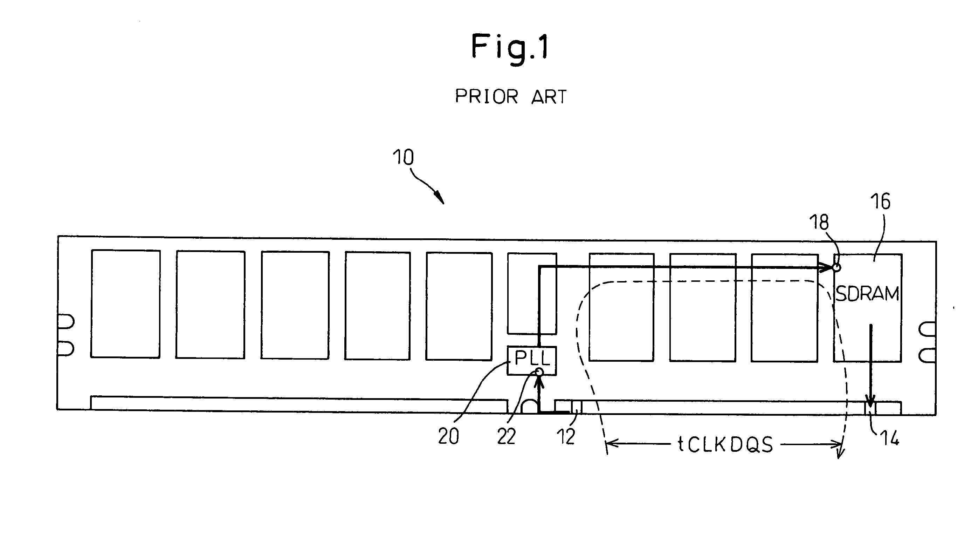

Before describing the embodiments of the present invention, a description will be given of how the adjustment of the timing of the clock signal is done at the time of the development of a memory module. Figure 1 shows the general configuration of a DIMM. The DIMM 10 shown here comprises a plurality of SDRAM devices 16 and a PLL-based clock driver 20 for distributing a clock signal to them.

In the DIMM 10, a differential clock signal CLK, /CLK input via a DIMM edge terminal is phase-adjusted by the PLL-based clock driver 20 before being distribution to the respective SDRAM devices 16. Here, /CLK is a substitute notation for CLK with a bar over it. Each SDRAM device 16 operates synchronously with the supplied clock signal, and outputs differential data DQS, /DQS to a DIMM edge terminal. In the DIMM 10, reference numeral 12 indicates a CLK terminal (or /CLK terminal), and 14 a DQS terminal (or /DQS terminal). The wiring pattern for the clock signal from the PLL-based clock driver 20 to the respective SDRAM devices 16 is designed so that the wiring length is the same for all the SDRAM devices 16.

When developing the DIMM 10, the feedback loop to be provided outside the PLL-based clock driver 20 is designed so that the phase difference of the clock signal between the clock input terminal 22 of the PLL-based clock driver 20 and the clock input terminal 18 of each SDRAM device 16 will be zero. Then, for the delay time tCLKDQS which defines the time from when the clock CLK is applied to the CLK terminal 12 until the memory output data DQS appears at the DQS terminal 14, its minimum value tCLKDQSmin and maximum value tCLKDQSmax are determined as specification values for the DIMM 10.

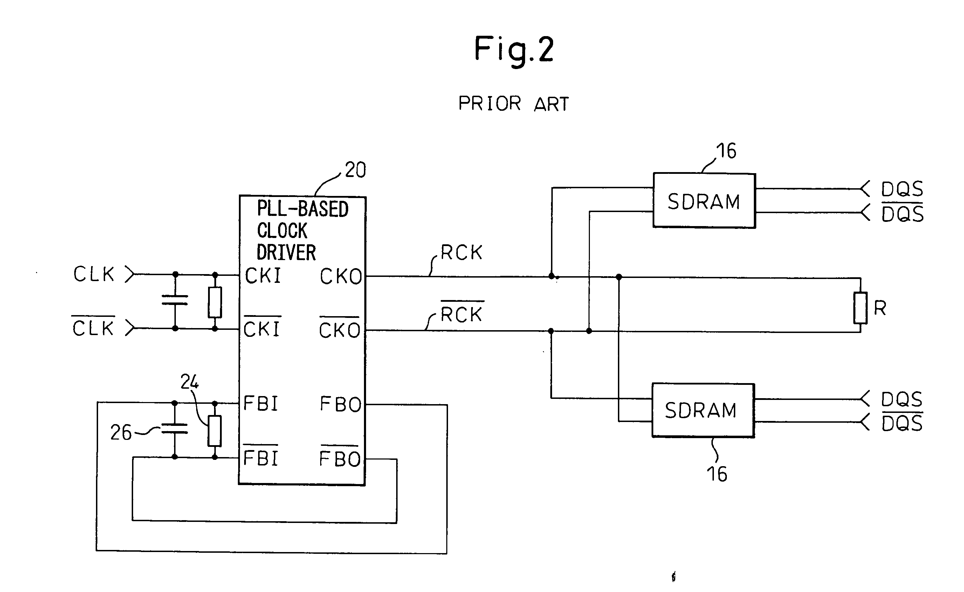

Figure 2 is a circuit diagram showing how the clock is distributed within the DIMM 10. As shown, the differential clock signals CLK and /CLK input from the edge terminal of the DIMM 10 are applied to the input terminals CKI and /CKI of the PLL-based clock driver 20. A resistor and a capacitor are connected in parallel between the CLK line and /CLK line.

The differential clock signals RCK and /RCK output from the output terminals CKO and /CKO of the PLL-based clock driver 20 are supplied to each SDRAM device 16. A termination resistor R is connected between the CKO line and /CKO line. The differential data DQS and /DQS output from each SDRAM device 16 are directed to the output edge terminal of the DIMM 10.

The differential signals output from the feedback output terminals FBO and /FBO of the PLL-based clock driver 20 are directed via the feedback loop to the feedback input terminals FBI and /FBI of the driver 20. A resistor 24 and a capacitor 26 are connected in parallel between the two lines forming the feedback loop.

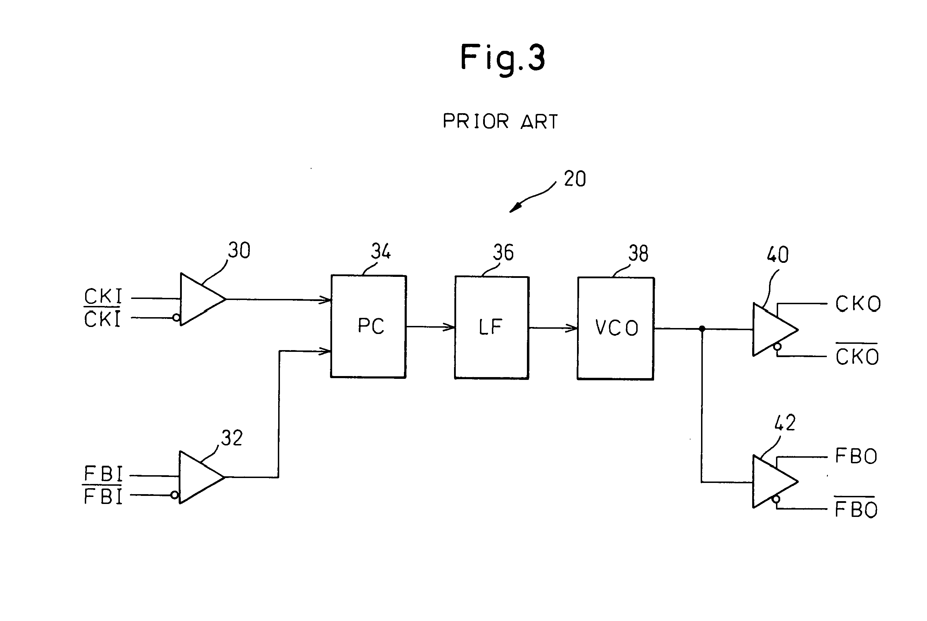

Figure 3 is a diagram showing the internal configuration of the PLL-based clock driver 20. First, the differential clock input CKI, /CKI is supplied via a buffer 30 to one input of a phase comparator (PC) 34. On the other hand, the differential feedback input FBI, /FBI is supplied via a buffer 32 to the other input of the phase comparator (PC) 34. The phase comparator (PC) 34 outputs a voltage proportional to the phase difference between the two inputs, and supplies it to a loop filter (LF) 36.

The loop filter (LF) 36, which is constructed from a low-pass filter, averages the output of the phase comparator (PC) 34 and supplies it to a voltage controlled oscillator (VCO) 38 at the next stage. The voltage controlled oscillator (VCO) 38 oscillates at a frequency proportional to the input voltage. Its output is presented as differential output clock signals CKO and /CKO via a buffer 40 and as differential feedback outputs FBO and /FBO via a buffer 42. Actually, a plurality of buffers 40 are provided, but only one such buffer is shown for simplicity of illustration.

In this way, the PLL-based clock driver 20 operates so that the phase of the feedback input FBI, /FBI matches the phase of the clock input CKI, /CKI. Accordingly, the phase of the output clock can be adjusted by varying the length of the feedback loop line and the load (resistor 24 and capacitor 26). When developing the DIMM 10, the length of the feedback loop line and the load are determined so that the phase of the input clock to the PLL-based clock driver 20 matches the phase of the input clock to each SDRAM device 16.

However, even when the DIMM board has been designed as described above, there are cases where SDRAMs from a manufacturer other than that of the SDRAMs mounted on the DIMM board when it was adjusted for phase may be mounted on the actual DIMM board. In such cases, there can arise the problem that the original phase adjustment does not match the actual DIMM because of differences in the input capacitance of the SDRAM. Furthermore, if the manufacturer is different, the access time of the SDRAM itself may also be different.

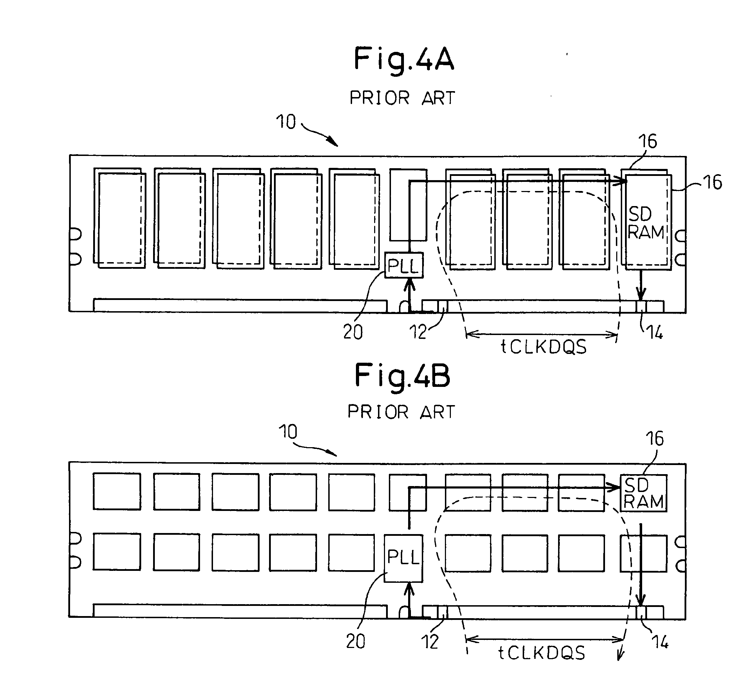

Similar problems arise when the SDRAMs are mounted in a double-decker style as shown in Figure 4A or when SDRAMs of different kinds are mounted in different quantities as shown in Figure 4B. As a result, the delay time tCLKDQS defining the time from when the clock is input to the DIMM until the output data is produced from the DIMM may significantly differ from that determined at the time of the phase adjustment.

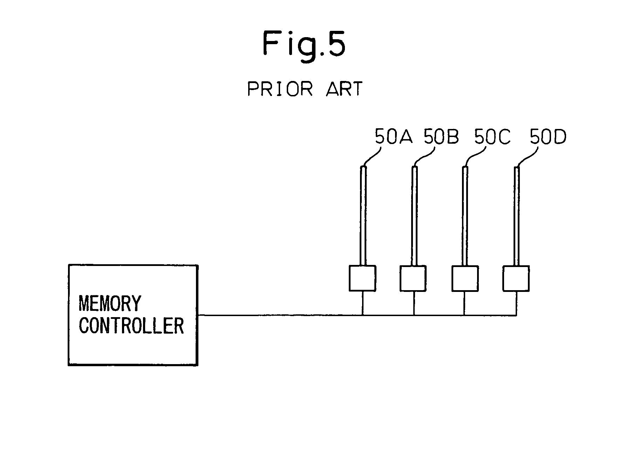

A difference can also occur depending on how the DIMM is mounted in the host apparatus. For example, when there are four slots 50A, 50B, 50C, and 50D as shown in Figure 5, differences occur in DIMM access time due to differences in the number of slots used, a mixture of DIMMs of different capacities, etc.

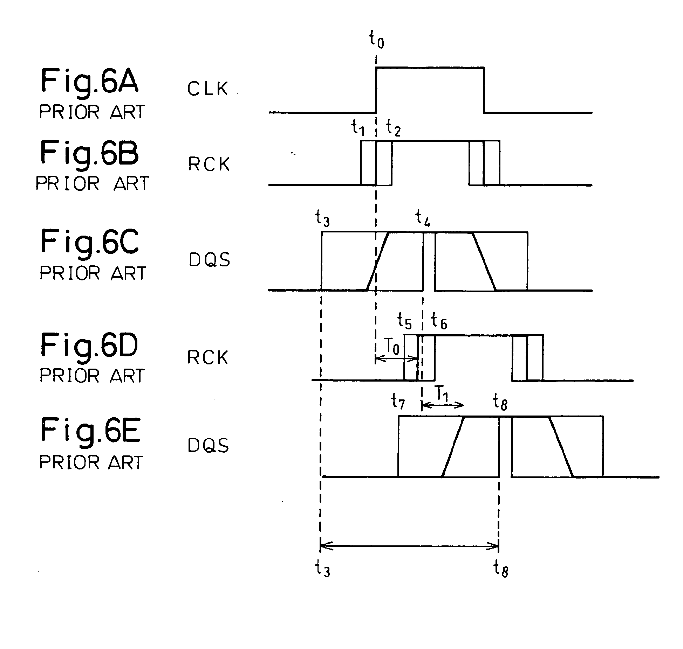

Figures 6A, 6B, 6C, 6D, and 6E are timing charts showing the relationships among the input clock CLK to the DIMM 10, the input clock RCK to the SDRAM 16, and the output data DQS from the DIMM 10. When developing the DIMM, the phase adjustment is done using the feedback loop so that the phase difference between the input clock CLK to the DIMM and the input clock RCK to the SDRAM becomes zero. However, because of differences between individual devices, the rise time of RCK varies within the range of t1 to t2 in relation to the rise time t0 of CLK.

Then, as shown in Figure 6C, the timing specification value for the output data DQS from the DIMM is also determined. That is, the rise time of DQS lies within the range of t3 to t4 in relation to the rise time t0 of CLK.

However, if the kind of the DIMM is different, for example, a phase shift T0 can occur between RCK and CLK, as shown in Figure 6D. In this case, the rise time of RCK varies within the range of t5 to t6 in relation to the rise time t0 of CLK. Further, if an additional shift T1 occurs due to differences in output load or in the access time of the SDRAM, the rise time of DQS is further shifted and lies within the range of t7 to t8, as shown in Figure 6E. Considering the above, the rise time of RCK can eventually vary within the range of t3 to t8 in relation to the rise time t0 of CLK.

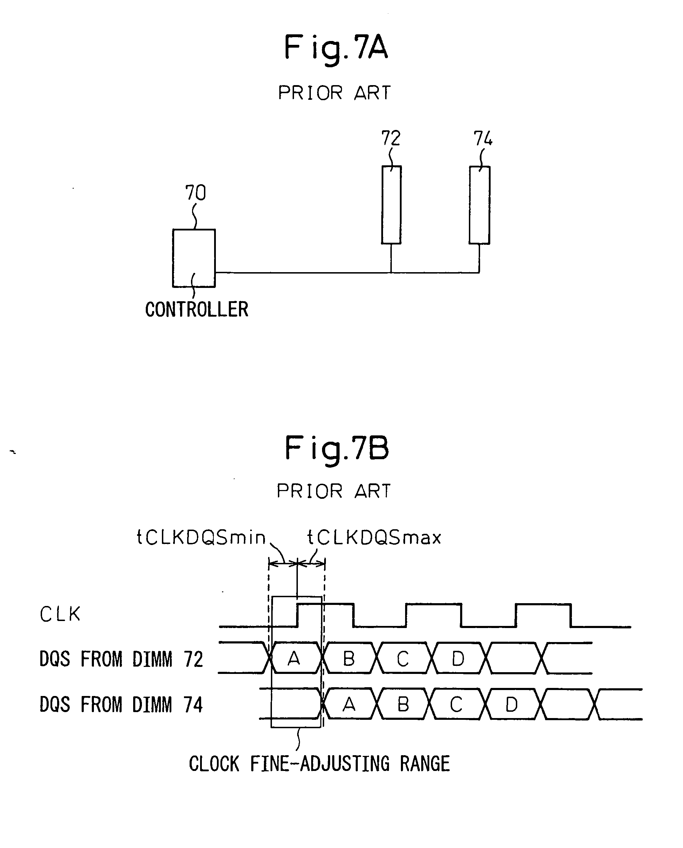

Figures 7A and 7B are diagrams for explaining how memory data are received by a controller. It is assumed that the controller 70 receives data by simultaneously accessing the DIMM 72 inserted in the first slot and the DIMM 74 inserted in the second slot, as shown in Figure 7A. The delay times from when the CLK is input to the DIMMs until the output data are produced from them are designated by tCLKDQSmin (a negative value) and tCLKDQSmax (a positive value), respectively.

If problems such as described earlier exist, in the worst case the relationships between the input clock CLK to the DIMMs 72 and 74, the output data DQS from the DIMM 72, and the output data DQS from the DIMM 74 would be as shown in the timing chart of Figure 7B. In that case, the controller 70 cannot receive the data from the DIMM 72 and the data from the DIMM 74 at the same time.

In view of the above, the present invention provides a memory module designed so that the phase of the clock to be distributed via the PLL circuit can be adjusted by an external signal, thereby making it possible to receive memory read data at the same time.

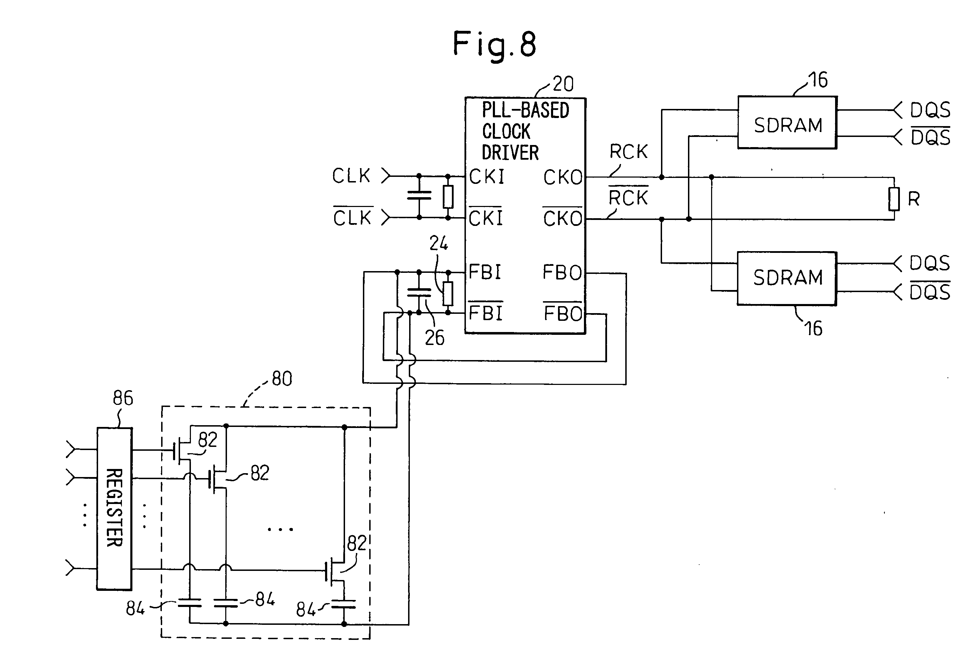

Figure 8 is a diagram showing the circuit configuration of a DIMM according to one embodiment of the present invention. As shown, the circuit differs from the circuit previously shown in Figure 2 by the inclusion of a capacitance switching circuit 80 and a register 86. Here, the register 86 may be provided on the controller side. As shown in the figure, the capacitance switching circuit 80 is constructed by paralleling a plurality of series connections each consisting of a transistor 82 and a capacitor 84, and the circuit as a whole is connected in parallel with the resistor 24 and capacitor 26 in the feedback loop.

The value of each bit in the register 86 controls the on/off operation of the corresponding transistor 82; that is, when the bit value is "0", the transistor 82 is cut off, and when the bit value is "1", the transistor 82 conducts. Accordingly, the controller for controlling the DIMM can vary the capacitance in the feedback loop by varying the value of the register and thereby controlling the number of capacitors 84 to be inserted in the feedback loop of the PLL.

In this way, as the load in the feedback loop can be programmably varied, if the SDRAMs mounted on the DIMM are changed, or if the use conditions of the DIMM are changed, the controller can make a phase adjustment in accordance with such changes. Here, the capacitance switching circuit 80 may be replaced by a resistance switching circuit having a similar circuit configuration. Alternatively, a circuit for varying both the capacitance and resistance may be provided.

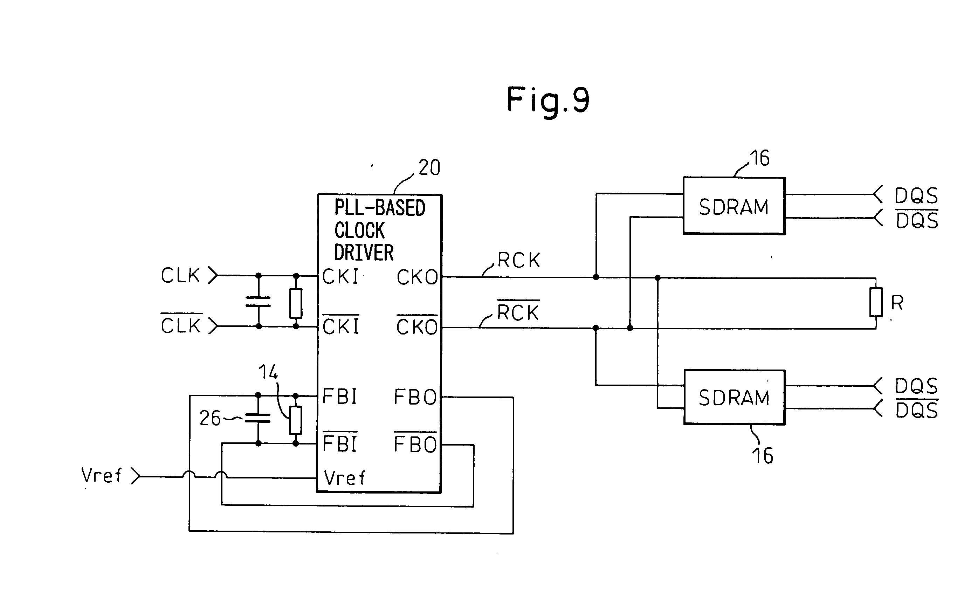

Figure 9 is a diagram for explaining a DIMM according to another embodiment of the present invention. In this embodiment, the controller supplies a signal Vref to the PLL-based clock driver 20. The signal Vref is a signal for varying the threshold of the buffer 32 in the PLL-based clock driver 20 shown in Figure 3.

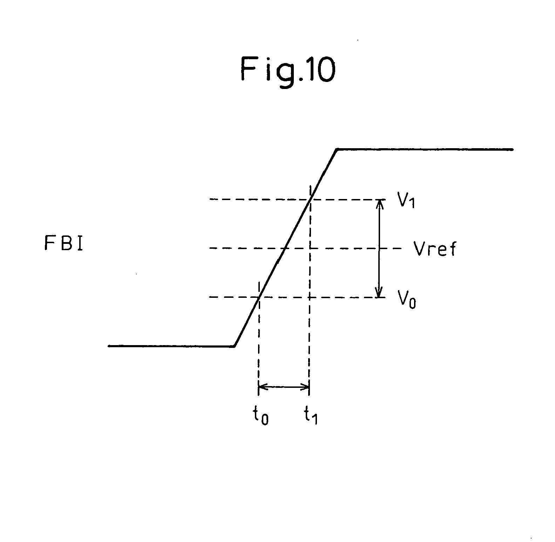

That is, as shown in Figure 10, when Vref is varied within the range of V0 to V1, the phase of FBI correspondingly varies within the range of t0 to t1. In this way, the change timing of the feedback input FBI is shifted by changing the reference voltage based on which the voltage value of the feedback input FBI is judged. As a result, the judgment in the phase comparator 34 (Figure 3) in the PLL-based clock driver 20 is also shifted. The phase adjustment can thus be accomplished.

The embodiments of the present invention have been described by dealing with DIMMs, but it will be appreciated that the present invention is not limited to this specific type of memory module, but the invention can also be applied to other types of memory module such as SIMMs (Single In-line Memory Modules).

The invention may be embodied in other specific forms without departing from the essential characteristics thereof. The present embodiment is therefore to be considered in all respects as illustrative and not restrictive, the scope of the invention being indicated by the appended claims rather than by the foregoing description and all changes which come within the meaning and range of equivalency of the claims are therefore intended to be embraced therein.

## Claims

1. A memory module having an array of memory devices mounted thereon that operate synchronously with a clock signal, comprising:
a phase-locked loop circuit which produces an output clock signal adjusted so that the phase of a feedback signal obtained by passing said output clock signal through a feedback loop matches the phase of an input clock signal; and
a switching unit which selectively changes a load in said feedback loop in accordance with an external signal.

2. A memory module as claimed in claim 1, wherein said switching unit changes a capacitance value in said feedback loop.

3. A memory module as claimed in claim 1, wherein said switching unit changes a resistance value in said feedback loop.

4. A memory module as claimed in claim 1, wherein said switching unit changes a capacitance value and a resistance value in said feedback loop.

5. A memory module as claimed in any preceding claim, wherein said switching unit selectively changes said load in said feedback loop in accordance with a value that is set in a register by a controller.

6. A memory module as claimed in claim 5, wherein said register is mounted on said memory module.

7. A memory module as claimed in any preceding claim, wherein said clock signal is implemented as a differential signal, and said load in said feedback loop is formed by a resistor and a capacitor connected in parallel between two lines.

8. A memory module having an array of memory devices mounted thereon that operate synchronously with a clock signal, comprising:
a phase-locked loop circuit which produces an output clock signal adjusted so that the phase of a feedback signal obtained by passing said output clock signal through a feedback loop matches the phase of an input clock signal; and
a unit which, in accordance with an external signal, changes a reference level based on which a phase comparator circuit in said phase-locked loop circuit judges the value of said feedback signal.
